# FASCICULE DE BREVET EUROPEEN

(11) **EP 2 033 215 B1**
(45) Date de publication et mention de la délivrance du brevet: **18.12.2019**
(21) Numéro de dépôt: 07766130.4
(22) Date de dépôt: 31.05.2007
(51) Int. Cl.: H01L 21/677, H01L 21/673

(54) **DISPOSITIF DE TRANSPORT, DE STOCKAGE ET DE TRANSFERT DE SUBSTRATS**
VORRICHTUNG FÜR TRANSPORT, LAGERUNG UND ÜBERTRAGUNG VON SUBSTRATEN
DEVICE FOR THE TRANSPORT, STORAGE AND TRANSFER OF SUBSTRATES

(30) Priorité: 09.06.2006 FR 0652080
(43) Date de publication de la demande: 11.03.2009
(73) Titulaire: Pfeiffer Vacuum, 74000 Annecy (FR)
(72) Inventeur: SYLVESTRE, Raphaël, F-26800 Montmoison (FR); GODOT, Erwan, F-71710 Moncenis (FR); SOGAN, Gloria, F-74330 Epagny (FR)
(74) Mandataire: Croonenbroek, Thomas Jakob
(86) Numéro de dépôt international: PCT/FR2007/051363
(87) Numéro de publication internationale: WO 2007/141447

(56) Documents cités:
- WO-A-2005/006407
- WO-A-2007/006166
- GB-A- 2 284 706
- JP-A- 11 087 459
- US-A1- 2001 041 530
- US-A1- 2003 106 830
- US-A1- 2006 105 498

## Description

La présente invention concerne le domaine du transport, au stockage et du transfert de substrats, notamment entre différentes étapes de la fabrication de composants microélectroniques, par exemple pour la réalisation de composants de microsystèmes électromécaniques (MEMS) ou de microsystèmes électrooptomécaniques (MOEMS). L'invention concerne plus particulièrement une boîte pour le transport et le stockage de substrats et une interface pour le transfert de ces substrats.

Les substrats se présentent notamment sous la forme de masques de forme carrée ou de tranches de forme circulaire en matériau semi-conducteur tel que le silicium.

Dans les dispositifs actuellement utilisés, entre les différentes étapes de fabrication des semi-conducteurs, les substrats sont transportés et stockés dans des boîtes de transport qui les protègent des pollutions particulaires présentes dans l'atmosphère des salles blanches. Habituellement, les boîtes de transport contiennent un substrat ou plusieurs substrats empilés. Un substrat peut être un masque ou une tranche de silicium, de 200 mm de diamètre ou de 300 mm de diamètre par exemple. Actuellement, les boîtes de transport couramment utilisées contiennent de 1 à 25 substrats.

WO 2005/006407 décrit un exemple de dispositif destiné au stockage de substrats.

Dans une boite de transport, les substrats sont empilés les uns à proximité des autres dans une sorte de râtelier monobloc que l'on désigne également par les appellations cassette ou panier.

Une boîte de transport comprend un corps de boîte avec une ouverture obturable par une porte, et un panier dans lequel peuvent être rangés des substrats.

Les boîtes de transport peuvent être accouplées avec des interfaces d'entrée-sortie des équipements de fabrication de semi-conducteurs. L'accouplement est réalisé à l'aide de sas à moyens robotisés. Un premier robot transporte chaque substrat individuellement depuis la boîte de transport vers un sas intermédiaire qui peut être une chambre de transfert, un sas de chargement. La chambre de transfert ou le sas de chargement est mis à basse pression. Puis le robot de la chambre de transfert transporte le substrat depuis le sas de chargement jusqu'à une chambre de procédé. L'espace disponible sous le substrat que l'on veut manipuler avec un robot doit être suffisant pour laisser passer le bras du robot sous le substrat dans un premier temps. Dans un deuxième temps, ce bras de robot doit pouvoir se soulever suffisamment, en déplaçant le substrat, pour que le substrat ne repose plus sur son support mais repose uniquement sur le bras du robot, qui va alors pouvoir déplacer le substrat vers la chambre de procédé.

Ainsi, le panier de la boîte de transport doit avoir une dimension suffisante pour que les substrats adjacents qu'il contient soient en permanence écartés d'une distance suffisante pour le passage d'un bras de robot. Il en résulte que les boîtes de transport, qui doivent contenir le panier, sont relativement volumineuses et ne peuvent pas contenir un grand nombre de substrats.

Or la place disponible pour le stockage dans une salle blanche est réduite à cause du coût de réalisation et d'entretien qu'elle représente. Le volume total des boîtes de transport qui peuvent y être stockées est limité, de sorte que cela constitue une limite au nombre de substrats que l'on peut stocker.

Les boîtes de transport peuvent être adaptées soit pour contenir une atmosphère à la pression atmosphérique, soit pour contenir une atmosphère à pression réduite ou atmosphère de vide. Dans ce dernier cas, la paroi de la boîte doit être renforcée pour supporter mécaniquement la pression externe sans déformation sensible ni dégradation. Il en résulte une paroi plus lourde, et le poids de la boîte peut devenir excessif pour les manipulations si la taille de la boîte est augmentée.

Il y a donc un besoin de diminuer l'encombrement et le poids des boîtes de transport et/ou d'augmenter le nombre de substrats qu'elles peuvent chacune contenir, afin d'utiliser au mieux le volume des salles blanches et de garantir la facilité de manutention des boîtes.

Les boîtes de transport présentent généralement l'avantage de pouvoir maintenir autour des substrats une atmosphère contrôlée, dans laquelle on évite autant que possible la présence de produits contaminants.

On utilise actuellement un premier type de boîte de transport désigné par l'acronyme SMIF (Standardized Mechanical Interface). Une telle boîte de transport comporte un corps de boîte en forme de cloche reposant sur une plaque de base qui ferme son ouverture inférieure et constitue une porte. Le panier est généralement posé ou tenu sur la plaque de base. Les substrats sont empilés horizontalement dans le panier.

Une description détaillée des boîtes de transport de type SMIF peut être trouvée notamment dans le brevet US 4,532,970,

Pour transférer des substrats depuis une boîte de transport SMIF vers une chambre de procédé, la boîte de transport est posée sur une interface qui ouvre sa porte inférieure et fait descendre l'ensemble du panier et des substrats qu'il contient jusque dans une enceinte d'interface. Les substrats sont ensuite retirés un à un du panier par un robot pour être introduits dans la chambre de procédé.

On utilise aussi actuellement un deuxième type de boite de transport, désigné par l'acronyme FOUP (Front Opening Universal Pod), comportant un corps de boîte à ouverture latérale.

Dans les deux cas, les substrats engagés dans le panier doivent être suffisamment écartés pour permettre la préhension d'un substrat choisi par un bras de robot, et le déplacement du substrat â l'écart de son support dans le panier.

La présente invention vise notamment à réduire l'encombrement des boîtes de transport ou inversement à augmenter leur capacité en nombre de substrats qu'elles contiennent à volume égal, afin d'optimiser le volume occupé dans les salles blanches dans lesquelles on les utilise.

Un autre but de l'invention est de simplifier les équipements, en diminuant les transferts, et en supprimant autant que possible les chambres de transfert ou sas de chargement.

L'invention a également pour but de réduire les risques de pollution des substrats lors de leurs déplacements dans les boîtes de transport et lors de leurs transferts dans et hors d'une boîte de transport, A cet égard, l'invention résulte d'une observation minutieuse des sources de pollution susceptibles d'affecter les substrats lors de l'utilisation de telles boîtes de transport.

D'autre part, l'invention vise à faciliter la décontamination des boîtes de transport et des paniers, entre les périodes d'utilisation.

Pour atteindre ces buts ainsi que d'autres, l'invention définie par l'objet de la revendication 1 propose tout d'abord une boîte de transport pour substrats tels que des substrats semi- conducteurs, ayant un corps de boîte muni de parois et comportant une ouverture, une porte obturant l'ouverture de manière étanche, et un panier logé dans le corps de boîte dans lequel peuvent être rangés des substrats.

Le panier est déplaçable à travers l'ouverture pour son logement dans le corps de boîte et pour sa sortie à l'extérieur au corps de boîte. Le panier est formé de l'empilement d'une série de plateaux parallèles, supportant chacun un substrat, les plateaux étant emboîtés les uns sur les autres lorsque le panier est dans le corps de boîte, et les plateaux étant déplaçables à l'écart les uns des autres, selon une direction de déplacement perpendiculaire au plan des substrats, lorsque le panier est à l'extérieur au corps de boîte.

Grâce au déplacement possible des plateaux les uns vis-à-vis des autres, on peut faire en sorte que, lorsque les plateaux sont empilés, les substrats soient relativement proches les uns des autres pour n'occuper qu'un faible volume, tandis que lors des opérations de transfert par un robot, les plateaux peuvent être écartés les uns des autres pour laisser la place du passage des bras de robot. Ainsi, lors du transport, les substrats étant plus rapprochés les uns des autres, la boîte de transport peut avoir un volume réduit ou contenir un plus grand nombre de substrats.

En outre, grâce à leur grande proximité les uns des autres tant tors des transports dans la boîte de transport que lors des déplacements du panier dans et hors de la boîte de transport, les substrats assurent entre eux une protection mutuelle qui réduit sensiblement les risques de pollutions particulaires sur les faces utiles des substrats.

De préférence, en position empilée des plateaux, le panier logé dans le corps de boîte est étroitement enveloppé dans le corps de boîte. On réduit ainsi le volume de l'atmosphère entourant les substrats dans la boîte de transport, ce qui réduit simultanément les risques de pollution par les gaz ou les particules présents dans cette atmosphère.

On dimensionnera de préférence les plateaux de façon que, en position empilée des plateaux, les substrats adjacents soient à proximité immédiate les uns des autres. On optimise ainsi la réduction de volume des boîtes de transport. Par exemple, en position empilée des plateaux, la distance entre les substrats adjacents pourra avantageusement être inférieure à 5 mm environ.

Dans une réalisation avantageuse, le panier est solidaire et entraîné par la porte. De la sorte, pour le transfert d'un panier vers l'intérieur ou vers l'extérieur du corps de boîte, il suffit de manœuvrer la porte de la boîte de transport.

Selon une première application, la boîte de transport peut être de type SMIF, à ouverture inférieure. Dans ce cas le panier est porté de préférence par la porte.

De préférence, en position empilée des plateaux, les zones périphériques des plateaux adjacents sont jointives sur une portion au moins du pourtour des substrats, assurant un confinement au moins partiel des substrats dans le panier. On isole ainsi au moins partiellement les substrats vis-à-vis de l'atmosphère qui environne le panier dans la boîte de transport, ce qui réduit encore le volume de l'atmosphère autour des substrats, et les risques de pollution sont encore réduits,

De préférence, les boîtes de transport comprennent des moyens pour comprimer les plateaux les uns contre les autres dans le corps de boîte lorsque celui-ci est fermé par la porte. On réduit ainsi les risques de déplacement relatif du panier par rapport au corps de boîte, déplacement susceptible de créer des portions par frottement ou déplacement gazeux.

Egalement, les plateaux sont avantageusement conformés de façon à serrer les substrats entre deux plateaux adjacents pendant le transport. On assure ainsi un maintien très efficace des substrats, réduisant les risques de détérioration des substrats en cas de chocs de la boîte de transport pendant sa manipulation. Cela réduit encore les risques de pollution des substrats.

Selon un mode de réalisation avantageux, chaque plateau comprend :
- un logement périphérique ouvert vers l'extérieur et apte à recevoir un verrou de blocage de plateaux,
- des faces principales opposées à formes emboîtantes pour coopérer avec les plateaux adjacents et pour assurer un blocage relatif des plateaux en déplacement transversal parallèlement aux plans des substrats,
- une face d'appui pour recevoir la première face d'une portion périphérique d'un substrat,
- une face de maintien pour venir en appui contre la seconde face de la portion périphérique d'un autre substrat,
- les faces d'appui et de maintien étant adaptées pour serrer la portion périphérique d'un substrat entre deux plateaux adjacents.

De préférence, la face de maintien comporte un arrondi, constituant une zone moins agressive pour la face correspondante du substrat, et assurant le centrage du substrat.

La face de maintien peut avantageusement comporter un relief élastique, tel qu'une languette élastiquement flexible, qui évite encore d'agresser la face correspondante du substrat.

En alternative, on peut prévoir des moyens assurant un maintien électrostatique des substrats sur les plateaux.

Selon un mode de réalisation avantageux, les plateaux sont conformés pour autoriser leur rotation relative les uns par rapport aux autres, dans leur plan, selon une plage angulaire permettant la correction de l'alignement des substrats qu'ils portent.

Selon un autre aspect, l'invention propose une interface destinée à coopérer avec au moins une boîte de transport, pour son accouplement avec un équipement de traitement des substrats, comprenant
- une enceinte d'interface comprenant un orifice d'accès pour s'accoupler à la boite de transport, de préférence de manière étanche au moyen d'un joint, et un orifice de passage coopérant avec l'équipement,
- des moyens de réception pour recevoir et tenir la boîte de transport, avec sa porte face à l'ouverture d'accès,
- des moyens d'actionnement de panier pour déplacer le panier contenant les substrats entre la boîte de transport et l'enceinte d'interface,
- un robot pour la préhension et le transfert des substrats entre le panier dans l'enceinte de l'interface et l'équipement,
- des moyens d'actionnement de plateaux adaptés pour écarter sélectivement un plateau choisi vis-à-vis d'un ou des plateaux adjacents, selon leur direction de déplacement, de façon à permettre au robot de prendre et déplacer sélectivement un substrat vers ou à l'écart du plateau choisi.

De préférence, l'interface comprend en outre des moyens d'actionnement de porte pour ouvrir et fermer la porte de la boîte de transport.

Dans le cas où le panier est accouplé à la porte de boîte de transport, les moyens d'actionnement de porte peuvent assurer aussi la fonction de moyens d'actionnement de panier.

L'interface peut comporter en outre un robot pour la préhension et le transfert des substrats entre le panier placé dans l'enceinte de l'interface et l'équipement,

Dans le cas où l'on utilise une boîte de transport à plateaux horizontaux, par exemple de type SMIF, les moyens d'actionnement de plateaux peuvent comprendre des moyens de verrouillage de plateau adaptés pour bloquer sélectivement le mouvement vers le bas d'un plateau choisi, afin d'écarter le plateau choisi vis-à-vis du plateau adjacent inférieur.

Alternativement, les moyens de verrouillage de plateau sont en outre adaptés pour bloquer sélectivement le mouvement vers le bas du plateau adjacent supérieur au plateau choisi, afin d'écarter le plateau choisi vis-à-vis du plateau adjacent supérieur.

Avantageusement, les moyens de verrouillage de plateau sont en outre adaptés pour bloquer sélectivement le mouvement vers le bas d'un plateau choisi et le mouvement vers le bas du plateau adjacent supérieur, afin d'écarter le plateau choisi à la fois vis-à-vis des deux plateaux adjacents.

Selon un mode de réalisation avantageux de l'interface, les moyens de verrouillage de plateau peuvent en outre être adaptés pour faire pivoter dans son plan le plateau qu'ils retiennent, selon une plage angulaire permettant la correction de l'alignement du substrat porté par le plateau vis-à-vis des autres substrats superposés.

Les boîtes de transport à plateaux horizontaux, permettent en outre de concevoir une utilisation particulièrement avantageuse, par laquelle les boîtes de transport constituent elles-mêmes une prolongation de l'interface et permettent en conséquence de réduire le volume de l'interface.

En effet, la hauteur d'interface peut être réduite, juste suffisante pour recevoir le panier avec les substrats empilés jointifs et seulement la hauteur supplémentaire nécessaire pour dégager le plateau supérieur et le substrat supérieur pour sa préhension. La préhension des substrats inférieurs peut s'effectuer alors que le panier est en partie engagé dans la boîte de transport.

Grâce à la petite dimension de l'interface, on peut aussi prévoir, selon l'invention, d'intégrer l'interface à l'intérieur même d'une chambre de transfert de l'équipement, telles qu'elles existent actuellement dans les installations de fabrication de composants microélectroniques.

On fait alors une économie de place, et on fait une économie de moyens de génération de vide.

D'autres objets, caractéristiques et avantages de la présente invention ressortiront de la description suivante de modes de réalisation particuliers, faite en relation avec les figures jointes, parmi lesquelles :
- la figure 1 est une vue schématique partielle en coupe d'une boîte de transport et de stockage selon un mode de réalisation de l'invention, en position de stockage ;
- la figure 2 est une vue schématique en coupe partielle d'un plateau pour le support d'une tranche de substrat ;
- les figures 3 et 4 sont des vues schématiques partielles en coupe montrant deux étapes de l'extraction d'un substrat hors de la boîte de transport selon l'invention, en vue de son transfert dans une chambre de procédé ; la figure 3 est une vue de face dans laquelle on distingue la sortie latérale du substrat ; la figure 4 est une vue de côté après rotation d'un angle de 90° par rapport à la figure 3, montrant la sortie postérieure du substrat ; et
- la figure 5 est une vue de dessus d'un plateau support de substrat selon un mode de réalisation de l'invention.

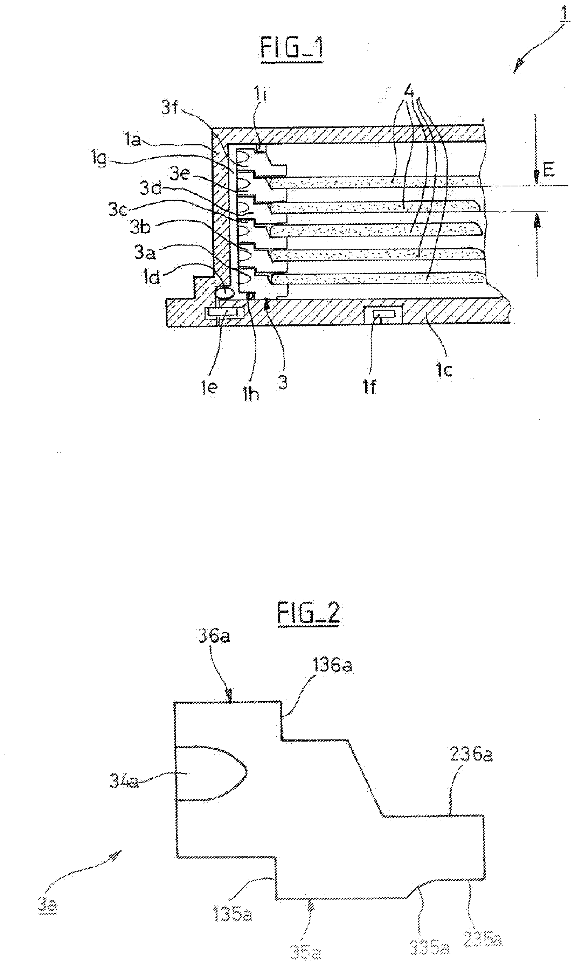

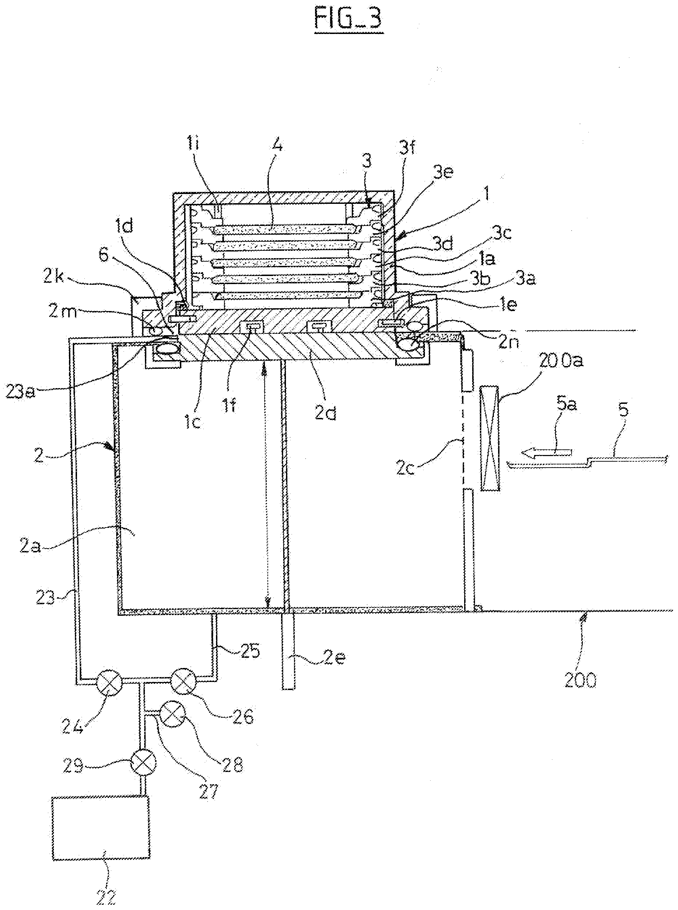

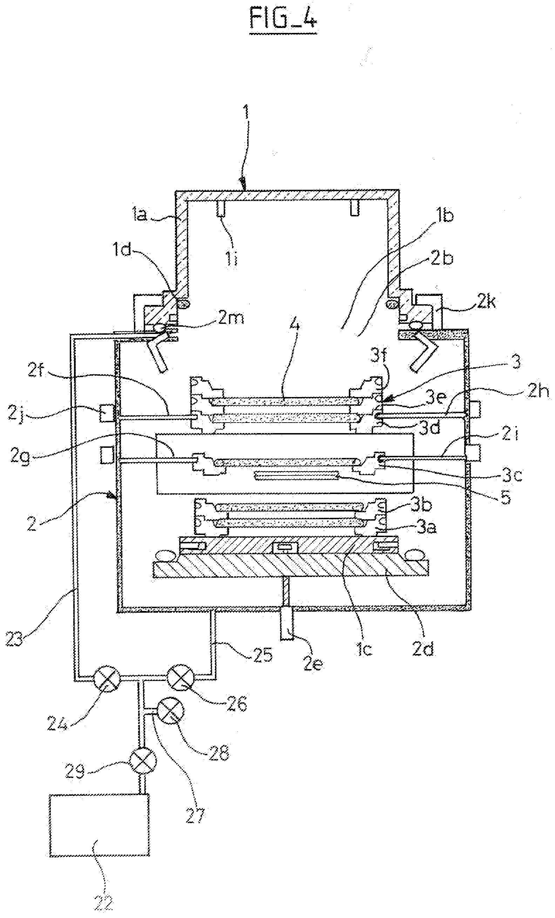

Dans le mode de réalisation illustré sur les figures, la boîte de transport 1 selon l'invention est une boîte de type SMIF. Sur la figure 1, la boîte de transport 1 est représentée isolée en position fermée. Sur la figure 3, la boîte de transport 1 est en position fermée, accouplée à une interface 2. Sur la figure 4 la boîte de transport 1 est illustrée en position ouverte, accouplée à l'interface 2.

La boîte de transport 1, dans ce mode de réalisation, comprend un corps de boîte 1a avec une ouverture 1b (figure 4) inférieure obturable par une porte 1c.

En position fonctionnelle de transport, la boîte de transport 1 contient un panier 3 dans lequel peuvent être rangés des substrats 4 à transporter.

Le panier 3 comprend une série de plateaux parallèles adaptés pour stocker chacun un substrat 4. Ainsi, sur les figures, on distingue les plateaux 3a, 3b, 3c, 3d, 3e et 3f. On comprendra que l'invention n'est pas limitée à un panier à six plateaux tel qu'illustré, mais que la boîte de transport 1 pourra contenir un nombre différent de plateaux en fonction de son volume et du volume occupé par chaque plateau.

Le corps de boîte 1a, dans une telle boîte de type SMIF, comporte des parois affectant une forme générale de cloche avec une partie périphérique de corps de boîte et une partie supérieure horizontale. La porte de boîte 1c, qui ferme de manière étanche l'ouverture inférieure 1b, est associée à un joint d'étanchéité 1d et à des moyens de verrouillage de porte de boîte 1e.

Pour l'ouverture et la fermeture, la porte de boîte 1c est déplacée verticalement, entre la position fermée illustrée sur les figures 1 et 3 et la position ouverte illustrée sur la figure 4.

Les moyens de verrouillage de porte de boîte 1e comprennent par exemple des loquets, portés par la porte de boîte 1c, et actionnés en coulissement radial par des moyens d'accouplement 1f eux-mêmes actionnés depuis l'interface 2, et s'engageant dans des logements prévus dans la paroi périphérique du corps de boîte 1a, comme illustré sur les figures.

Selon un mode de réalisation, les moyens d'accouplement 1f peuvent être des moyens d'accouplement mécaniques de type clé s'engageant dans une serrure.

Ce mode d'accouplement mécanique présente toutefois l'inconvénient de générer des frottements mécaniques entre la clé et son logement, frottements susceptibles de produire des particules polluantes que l'on retrouve tôt ou tard sur les substrats. Ainsi, pour réduire ce risque de pollution, on peut envisager des moyens d'accouplement 1f de type magnétique.

Lorsque la boite est fermée, comme illustré sur les figures 1 et 3, les plateaux 3a-3f sont emboîtés les uns sur les autres. Chaque plateau 3a-3f soutient un seul substrat 4. Dans cette position, les plateaux adjacents, tels que les plateaux 3a et 3b, sont en contact directement l'un avec l'autre.

Les plateaux 3a-3f peuvent être en matière plastique.

En position empilée des plateaux, lorsque la boîte de transport 1 est fermée, comme illustré sur les figures 1 et 3, le panier 3 logé dans le corps de boîte la est étroitement enveloppé dans le corps de boîte 1a. De la sorte, les bords du panier 3 sont à proximité immédiate de la paroi latérale du corps de boîte 1a, laissant seulement un interstice périphérique 1g de volume très réduit. Le plateau inférieur 3a est directement en contact de la porte de boîte 1c. Le plateau supérieur 3f est directement en contact avec la paroi supérieure du corps de boîte 1a, laissant également des interstices inférieur et supérieur de volumes très réduits.

En outre, lorsque les plateaux 3a-3f du panier 3 sont empilés les uns sur les autres et contenus dans la boite de transport 1, la porte de boîte 1c étant fermée, la pile des plateaux 3a-3f est maintenue comprimée par des moyens pour comprimer les plateaux les uns contre les autres dans le corps de boîte fermé par la porte de boîte 1c. Dans la réalisation illustrée sur les figures, la pile des plateaux 3a-3f est comprimée par des butées élastiques 1h et 1i, par exemple des joints annulaires en matériaux élastiques tels que des polymères ou des perfluoroélastomères résistants aux agressions chimiques.

Les plateaux 3a-3f sont déplaçables à l'écart les uns des autres, selon une directon de déplacement perpendiculaire au plan des substrats 4, lorsque la porte 1c est ouverte, et que le panier 3 est au moins partiellement contenu dans l'interface 2. La figure 4 illustre cette possibilité de déplacement : on voit que, par rapport aux plateaux inférieurs 3a et 3b qui reposent sur la porte de boîte 1c, le plateau intermédiaire 3c est surélevé, et les plateaux supérieurs 3d, 3e et 3f sont eux-mêmes surélevés par rapport au plateau intermédiaire 3c. Le mouvement relatif s'effectue selon l'axe vertical, perpendiculairement au plan horizontal selon lequel sont disposés les substrats 4. Cette possibilité de déplacement vertical permet de réaliser, de part et d'autre du plateau intermédiaire 3c un espace suffisant permettant tout d'abord le passage d'un bras de robot 5 (figure 4), puis le soulèvement du substrat intermédiaire 4a au-dessus du plateau 3c pour autoriser ensuite son déplacement horizontal à l'écart du panier 3.

A l'inverse, lorsque les plateaux 3a-3f sont empilés les uns sur les autres, comme illustré sur les figures 1 et 3, alors l'espace entre deux substrats successifs peut être très inférieur à l'espace nécessaire pour le passage d'un bras de robot 5 et pour le déplacement vertical d'un substrat avant son déplacement horizontal.

Comme on le voit sur les figures 1 et 3, en position empilée des plateaux 3a-3f, les zones périphériques des plateaux adjacents sont jointives sur une portion au moins du pourtour du substrat 4, assurant un confinement au moins partiel des substrats 4 dans le panier 3.

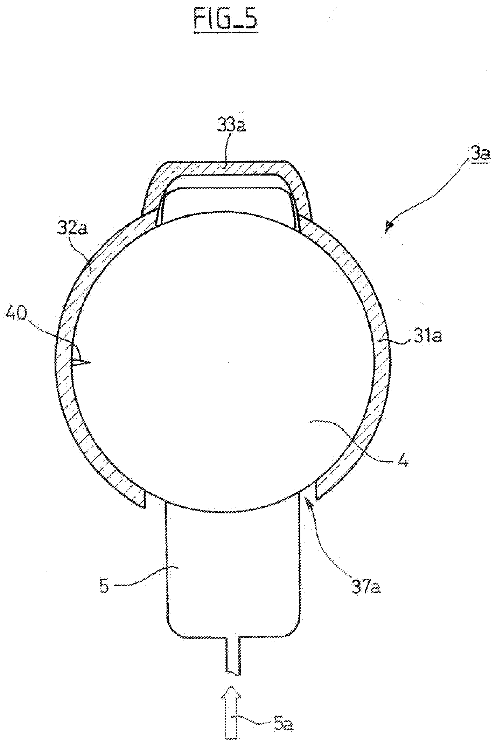

Dans le mode de réalisation illustré plus en détail sur les figures 2 et 5, chaque plateau tel que le plateau 3a est, en vue de dessus sur la figure 5, une structure en forme générale de fer à cheval, avec deux branches latérales opposées 31a et 32a dont les premières extrémités sont reliées par une traverse 33a et dont les secondes extrémités sont à l'écart l'une de l'autre pour laisser un passage frontal 37a permettant le déplacement du bras du robot 5. Les branches latérales 31a et 32a ont un profil adapté au contour du substrat 4 à porter. Par exemple, elles sont incurvées pour tenir un substrat 4 en forme de disque, elles sont rectilignes pour tenir un substrat rectangulaire.

En coupe transversale illustrée sur la figure 2, on voit que le plateau 3a comporte un logement périphérique 34a ouvert vers l'extérieur. Ce logement périphérique 34a est apte à recevoir un verrou de blocage de plateaux, comme cela sera décrit en relation avec la figure 4. Le plateau 3a comprend par ailleurs des faces principales opposées 35a et 36a à formes emboîtantes pour coopérer avec les plateaux adjacents et assurer un blocage relatif en déplacement transversal parallèlement aux plans des substrats 4. En pratique, la face 35a comporte un épaulement 135a, et la face 36a comprend un épaulement 136a, les épaulements 135a et 136a étant positionnés de façon à permettre l'emboîtement relatif de deux plateaux superposés.

La face supérieure 36a comprend une face d'appui 236a conformée pour recevoir la première face d'une portion périphérique d'un substrat 4. La face inférieure 35a comprend une face de maintien 235a pour venir en appui contre la seconde face de la partie périphérique d'un autre substrat. Les faces d'appui 236a et de maintien 235a sont adaptées pour serrer entre elles la portion périphérique d'un substrat 4 entre deux plateaux adjacents, comme on le voit sur les figures 1 et 3.

Dans la réalisation illustrée sur la figure 2, la face de maintien 235a comporte un arrondi 335a, qui participe au serrage et assure un centrage relatif du substrat 4 tenu par le plateau 3a.

Selon un mode de réalisation avantageux, la face de maintien 235a peut comporter un relief élastique, non illustré sur les figures. Un tel relief élastique peut par exemple être une languette élastiquement flexible, dont une première extrémité est solidaire de la face de maintien 235a et qui travaille en flexion avec sa zone d'extrémité opposée venant en appui élastique sur le substrat 4.

En utilisation, les substrats 4 reposent sur les faces d'appui 236a planes des plateaux. Ces faces d'appui 236a doivent être parfaitement propres et exemptes de particules polluantes.

La forme arrondie des faces de maintien 235a permet le guidage et le pincement d'un substrat sur son bord extérieur, ce qui permet de ne pas entrer en contact avec la surface active du substrat, évitant un risque de contamination supplémentaire.

Lorsque la boîte de transport 1 est fermée, pour le stockage ou le transport, la face de maintien 235a est en appui sur un substrat immédiatement au-dessous du plateau 3a, et maintient en position fixe la tranche de substrat afin de prévenir toute dégradation pendant le déplacement de la boîte de transport 1. Tous les substrats 4 sont maintenus pincés selon leur pourtour, et l'ensemble des plateaux 3a-3f est fixé par compression des moyens de compression 1h et 1i entre la paroi supérieure du corps de boîte 1a et la porte de boîte 1c. La boîte de transport 1 peut alors être manipulée dans toutes les directions sans risquer de déplacer les substrats 4 dans le panier 3. Le maintien des substrats 4 est assuré de manière fiable, indépendamment du fait que la boîte de transport 1 soit complètement ou partiellement rempile de substrats 4. En effet, même si certains plateaux ne soutiennent pas de substrats, le fait que fous les plateaux 3a-3f soient comprimés ensemble et que chaque couple de deux plateaux consécutifs pince le substrat entre eux, permet de maintenir fixés tous les substrats présents par rapport à la boîte de transport 1.

En considérant la figure 1, l'intervalle E entre deux substrats consécutifs, lorsque les plateaux 3a-3f sont empilés les uns sur les autres, est réduit à 2 ou 3 mm, au lieu des 10 mm environ qui sont actuellement nécessaires dans les boîtes de transport connues. Grâce à cette disposition, rendue possible par le mouvement relatif des plateaux les uns vis-à-vis des autres, une boîte de transport actuelle prévue pour le transport d'un substrat unique peut être utilisée, selon l'invention, pour contenir jusqu'à cinq substrats, sans avoir à modifier la géométrie de l'enveloppe de la boîte de transport.

On considère maintenant les figures 3 et 4, qui illustrent la boîte de transport 1 accouplée à une interface 2 selon un mode de réalisation de l'invention.

Dans ce mode de réalisation, l'interface 2 permet l'accouplement d'une boîte de transport 1 avec un équipement de traitement des substrats 200, schématiquement illustré sur la figure 3. Le but est de transférer des substrats entre la boîte de transport 1 et l'équipement 200, par l'intermédiaire de l'interface 2.

Le corps de boîte 1a est tenu sur l'interface 2 par des moyens de réception 2k tels que des brides amovibles.

L'interface 2 comprend une enceinte d'interface 2a. ayant un orifice d'accès 2b supérieur en correspondance avec l'ouverture 1b de la boîte de transport 1, et ayant un orifice de passage 2c latéral en correspondance de l'équipement 200 et obturable par une porte d'équipement 200a.

Une porte d'interface 2d est adaptée pour obturer sélectivement l'orifice d'accès 2b, et est pour cela déplaçable verticalement par l'action d'un vérin 2e.

En position d'assemblage de la boîte de transport 1 sur l'interface 2, on solidarise la porte 1c de boîte de transport sur la porte d'interface 2d par les moyens d'accouplement 1f. De la sorte, le vérin 2e constitue un moyen d'actionnement de porte pour ouvrir et fermer la porte 1c de la boîte de transport 1, et constitue simultanément un moyen d'actionnement de panier pour déplacer le panier 3 contenant les substrats 4 entre la boîte de transport 1 et l'enceinte 2a de l'interface 2.

Dans le cas d'un accouplement par des moyens d'accouplement 1f mécaniques de type clé de porte d'interface 2d engagée dans une serrure de la porte de boîte 1c, les particules polluantes résultant des frottements s'échappent dans l'atmosphère intérieure sous vide de la boîte de transport 1 et de l'interface 2, du fait que l'ensemble porte de boîte 1c-porte d'interface 2d se trouve dans l'atmosphère à pression réduite qui contient elle-même les substrats 4 à traiter. On préférera donc des moyens d'accouplement 1f de type magnétique.

Dans le mode de réalisation représenté, l'équipement 200 comprend un robot 5 pour la préhension et le transfert des substrats 4 entre le panier 3 situé dans l'enceinte d'interface 2a et l'équipement 200. On voit que le robot 5 assure un déplacement horizontal selon la flèche 5a, pour venir s'engager sous un substrat comme illustré sur les figures 4 et 5. En alternative, le robot pourrait faire partie de l'interface 2.

L'interface 2 comprend en outre des moyens d'actionnement de plateaux adaptés pour écarter sélectivement un plateau choisi vis-à-vis d'un ou des plateaux adjacents selon leur direction de déplacement (la direction verticale sur le mode de réalisation illustré sur les figures), de façon à permettre au robot 5 de prendre et déplacer sélectivement un substrat 4 vers ou à l'écart du plateau choisi.

Dans la réalisation illustrée sur les figures, les moyens d'actionnement de plateaux comprennent des moyens de verrouillage de plateau qui bloquent sélectivement le mouvement vertical de certains plateaux choisis.

En pratique, les moyens de verrouillage de plateau sont des doigts de verrouillage 2f, 2g, 2h et 21, sollicités par des moteurs ou vérins correspondants tels que le vérin 2j du doigt de verrouillage 2f, pour être déplacés radialement vers et à l'écart des plateaux. L'extrémité de chaque doigt de verrouillage peut s'engager dans un logement du plateau correspondant par l'action d'un vérin.

Par exemple, on considère le plateau 3d situé juste au-dessus du plateau 3c portant le substrat 4a que l'on choisit d'extraire ; lorsque ce plateau 3d est à la hauteur souhaitée, les doigts de verrouillage 2f et 2h bloquent la descente du plateau 3d, tandis que la descente du plateau 3c se poursuit par l'action du vérin 2e. Ensuite, lorsque le substrat 4a est à la hauteur voulue, les doigts de verrouillage 2g et 2i bloquent la descente du plateau 3c, tandis que la descente des plateaux 3b et 3a se poursuit par l'action du vérin 2e. On réalise ainsi un espace suffisant à la fois au-dessous du substrat 4a et au-dessus du substrat 4a comme illustré sur la figure 4, pour l'engagement du robot 5 sous le substrat 4a et le soulèvement du substrat 4a par le robot 5 pour le détacher du plateau 3c.

On comprend que les doigts de verrouillage 2f-2i s'engagent dans les logements périphériques 34a respectifs des plateaux 3a-3f.

Avantageusement, les doigts de verrouillage tels que le doigt 2f comportent deux points d'appui, pour une meilleure stabilité.

Selon une possibilité avantageuse, pour limiter encore la pollution par création de particules, les moyens de verrouillage de plateau peuvent comporter un ou plusieurs électroaimants disposés à l'extérieur de l'interface 2, et chaque plateau 3a-3f peut comporter un élément ferromagnétique permettant d'être sollicité par l'électroaimant pour le verrouillage sélectif du plateau en position verticale.

On choisit la position des doigts de verrouillage 2f-2i en hauteur de telle sorte que l'espace libéré au-dessus du substrat sélectionné 4a soit suffisant pour permettre au substrat 4a d'être soulevé par le robot 5 pour être déplacé ensuite vers l'équipement 200,

On choisit également la hauteur des doigts de verrouillage, de telle sorte que l'espace libéré au-dessous du substrat sélectionné 4a soit suffisant pour permettre au robot 5 de passer sous le substrat 4a,

Les doigts de verrouillage 2f-2i sont placés selon les côtés de l'interface 2 qui sont perpendiculaires au côté ayant l'orifice de passage 2c vers l'équipement 200, Les doigts de verrouillage agissent sur les parties latérales des plateaux 3a-3f, de part et d'autre de la direction de déplacement des substrats 4 vers et à l'écart de l'équipement 200. De la sorte, les doigts de verrouillage 2f-2i ne s'opposent pas au déplacement du robot 5 et des substrats 4 entre l'interface 2 et l'équipement 200.

Le traitement des substrats 4 dans l'équipement 200 nécessite d'orienter chaque substrat 4 de manière précise dans la chambre de procédé. L'alignement est facilité lorsqu'il est déjà réalisé dans la boîte de transport 1 ou au moins dans l'interface 2. Pour cela, selon l'invention, on peut prévoir des moyens pour réaliser ou au moins corriger cet alignement, par pivotement contrôlé des plateaux les uns vis-à-vis des autres : les doigts de verrouillage 2g et 2i qui portent le plateau 3c (figure 4) sont motorisés de façon à faire pivoter dans son plan le plateau 3c qu'ils retiennent, selon une plage angulaire adaptée permettant la correction d'alignement du plateau 3c, Cet alignement est repéré par la détection de position d'un repère tel qu'une encoche 40 (figure 5) ou autre marque prévue sur le pourtour du substrat 4a.

En alternative, la correction d'alignement peut être assurée par des moyens de rotation embarqués sur le robot 5 de l'interface 2 ou de l'équipement 200.

Considérons maintenant la succession des états du dispositif de l'invention au cours des étapes du fonctionnement pour le transfert de substrats 4 entre une boite de transport 1 et un équipement 200.

Dans un premier temps, la boite de transport 1 est accouplée à l'interface 2, les portes 1c et 2d étant fermées. Les moyens de réception 2k fixent le corps de boîte 1a à l'interface 2, comme illustré sur la figure 3. Des moyens d'accouplement détachables 1f solidarisent la porte de boîte 1c à la porte d'interface 2d, et actionnent les moyens de verrouillage 1e pour déverrouiller la porte de boite 1c vis-à-vis du corps de boîte 1a.

Les moyens d'actionnement de porte, constitués par le vérin 2e, déplacent alors en bloc les deux portes 1c et 2d verticalement à l'écart du corps de boîte 1a à l'intérieur de l'enceinte 2a de l'interface 2.

Sur la figure 4, la porte étant ouverte, le vérin 2e a fait pénétrer le panier 3 et les substrats 4 dans l'interface 2 à travers l'orifice d'accès 2b supérieur, les plateaux disposent alors de l'espace nécessaire pour être déplacés à l'écart les uns des autres. Les doigts de verrouillage 2f-2i ayant isolé le plateau 3c et le substrat 4a qu'il porte, le robot 5 peut alors soulever le substrat 4a et le déplacer horizontalement vers l'équipement 200 à travers l'orifice de passage 2c latéral de l'interface 2.

Si l'on souhaite sélectionner un autre substrat, par exemple le substrat porté par le plateau 3d, le vérin 2e déplace les portes 1c et 2d en mouvement inverse vers le haut, ce qui a pour effet de remonter la pile des plateaux inférieurs 3a et 3b jusqu'à hauteur du plateau 3c, les doigts de verrouillage 2g et 2i peuvent s'escamoter. Le vérin 2e remonte la pile des trois plateaux 3a, 3b et 3c jusqu'à hauteur du plateau 3d. Les doigts de verrouillage 2f et 2h peuvent être escamotés. Ensuite, le vérin 2e déplace la pile de plateaux d'un pas vers le bas, les doigts de verrouillage 2f et 2h verrouillent le plateau 3e, le vérin 2e poursuit sa descente, les doigts de verrouillage 2g et 2i verrouillent le plateau 3d, le vérin 2e poursuit sa descente de sorte que le plateau 3d est alors isolé pour la prise du substrat qu'il porte.

En fin de transfert des substrats, le vérin 2e remonte les portes 1c et 2d jusqu'à fermeture de la boîte de transport 1 et de l'interface 2 comme illustré sur la figure 3. On verrouille la porte de boîte de transport 1c avec ses moyens de verrouillage 1e, et on peut déverrouiller les moyens de réception 2k pour séparer la boîte de transport 1 vis-à-vis de l'interface 2.

Selon un mode de réalisation avantageux, la boîte de transport 1 selon l'invention permet de conserver une atmosphère contrôlée autour des substrats 4, afin d'éviter leur contamination pendant les étapes de transport et de stockage, en assurant une étanchéité suffisante de manière simple et à faible coût. De préférence l'atmosphère intérieure contrôlée est à pression réduite.

Pour cela, on peut avantageusement prévoir que la paroi périphérique du corps de boîte 1a est étanche, et que la porte de boîte 1c s'adapte sur le corps de boîte 1a avec interposition de joints d'étanchéité 1d tels qu'illustrés sur les figures. Les moyens de verrouillage de porte de boîte 1c doivent de préférence être adaptés pour maintenir à l'état élastiquement comprimé les joints d'étanchéité 1d de la porte de boîte 1c lorsque celle-ci est fermée.

Dans le mouvement de fermeture de la boîte de transport 1, le vérin 2e de l'interface 2 applique sur les portes de boîte 1c et d'interface 2d une poussée axiale vers la boîte de transport 1, comprimant le joint d'étanchéité de porte 1d avec un léger excès, de façon à permettre le coulissement libre à frottement faible ou nul des moyens de verrouillage de porte de boîte 1e, évitant la génération de particules polluantes. Ce mouvement de poussée avec excès est rendu possible par les butées élastiques 1i et 1h, qui autorisent un déplacement avec excès de la porte de boîte 1c vers l'intérieur de la boîte de transport 1 sans être bloqué par la pile des plateaux 3. Après verrouillage, on laisse revenir la porte de boîte 1c, sous la poussée élastique des butées élastiques 1h et 1i et du joint d'étanchéité 1 d de la porte de boîte 1c.

Un joint d'étanchéité frontal d'interface 2m est interposé entre la boîte de transport 1 et l'interface 2 pour assurer, entre la boîte de transport 1 et la paroi entourant l'orifice d'accès 2b de l'interface 2 une étanchéité vis-à-vis de l'atmosphère extérieure autour de l'orifice d'accès 2b et de l'ouverture 1b de la boîte de transport 1.

On comprend que les moyens de réception 2k à brides amovibles sollicitent la boîte de transport 1 en direction de l'interface 2, en comprimant le joint d'étanchéité frontal d'interface 2m, qui est éventuellement déformé comme représenté.

Le joint d'étanchéité frontal d'interface 2m constitue un moyen d'étanchéité périphérique qui isole de l'atmosphère extérieure une zone d'accouplement 6 entre les faces frontales respectives de la boîte de transport 1 et de l'interface 2 autour de l'ouverture 1b de boîte de transport 1 et de l'orifice d'accès 2b de l'interface 2. La zone d'accouplement 6 est le volume gazeux emprisonné, dans la position illustrée sur la figure 3, entre la porte de boîte 1c, la porte d'interface 2d, le joint d'étanchéité de boîte 1d, le joint d'étanchéité frontal d'interface 2m et un joint d'étanchéité de porte d'interface 2n. Lorsque l'on ouvre la porte de boîte 1c et la porte d'interface 2d, ce volume se trouve directement en communication avec la cavité interne de la boite de transport 1 et de l'interface 2. Initialement, le volume de cette zone d'accouplement 6 se trouve à la pression atmosphérique, c'est-à-dire avec une quantité de gaz non négligeable, et il apparaît utile de prévoir des moyens de pompage pour faire le vide dans cette zone d'accouplement 6 et pour évacuer ainsi la plus grande part des éléments polluants qu'elle peut contenir. Pour cela, on prévoit des moyens de pompage de liaison.

Dans le mode de réalisation illustré sur les figures 3 et 4. les moyens de pompage de liaison comprennent une canalisation de pompage de liaison 23, dont l'orifice d'entrée 23a communique avec le volume de la zone d'accouplement 6, et dont la sortie est connectée avec un dispositif de pompage à vide telle qu'une pompe 22, avec interposition d'une vanne de commande de pompage de liaison 24.

Le dispositif de pompage à vide est aussi connecté, par une canalisation de pompage d'interface 25, à l'espace intérieur de l'interface 2, avec interposition d'une vanne de commande de pompage d'interface 26.

Les moyens de pompage de liaison sont en outre adaptés pour établir sélectivement, dans le volume de la zone d'accouplement 6. une pression sensiblement égale à la pression environnante à l'extérieur du dispositif. Pour cela, une canalisation d'équilibrage 27, munie d'une vanne d'équilibrage 28, relie la canalisation de pompage de liaison 23 et/ou le volume de la zone d'accouplement 6 avec une injection de gaz de purge tel que l'azote ou avec l'extérieur du dispositif. Une vanne d'isolement 29 permet d'isoler la pompe 22 lors des phases de remise sous pression.

Les moyens de pompage de liaison comprennent en outre des moyens de commande tels que des microprocesseurs ou microcontrôleurs afin de piloter les pressions gazeuses régnant dans l'interface 2 et dans le volume de la zone d'accouplement 6, en pilotant la pompe 22 ainsi que les vannes 24, 26, 28 et 29, en fonction de signaux reçus de différents capteurs, non illustrés sur les figures, et en fonction d'un programme enregistré.

De la sorte, les moyens de pompage de liaison sont adaptés pour établir des équilibrages de pression lors des différentes étapes de fonctionnement.

Par exemple, lors de l'étape d'accouplement d'une boîte de transport 1 contre l'interface 2, le volume de la zone d'accouplement 6 est tout d'abord à la pression atmosphérique, alors que l'atmosphère intérieure de la boîte de transport 1 peut être à une première pression basse, et l'interface 2 peut être à une seconde pression basse éventuellement différente de la pression de la boîte de transport 1. Avant l'ouverture de la porte de boîte 1c et de la porte d'interface 2d, les moyens de pompage de liaison 22-29 peuvent établir, dans le volume de la zone d'accouplement 6, une pression gazeuse sensiblement égale à la pression dans la boîte de transport 1.

Si nécessaire, les moyens de pompage de liaison 22-29 établissent, dans l'interface 2, une pression gazeuse sensiblement égale à la pression dans la boîte de transport 1, la porte d'équipement obturant l'orifice de passage latéral 2c de l'interface 2. On peut ensuite, ouvrir les portes de boîte 1c et d'interface 2d. Ensuite, les moyens de pompage de liaison établissent sélectivement, dans l'interface 2 et dans la boîte de transport 1, une pression gazeuse sensiblement égale à la pression dans l'équipement 200. On peut alors ouvrir la porte d'équipement 200a qui obture l'orifice de passage latéral 2c, pour le transfert des substrats entre la boîte de transport 1 et l'équipement 200,

Au cours d'une étape ultérieure, par exemple après transfert des substrats, on ferme la porte d'équipement 200a pour obturer l'orifice de passage latéral 2c, et les moyens de pompage de liaison 22-29 peuvent alors être adaptés pour établir sélectivement dans l'interface 2 et dans la boîte de transport 1 une pression gazeuse sensiblement égale à la pression désirée dans la boîte de transport 1. On ferme ensuite les portes de boîte 1c et d'interface 2d, les moyens de pompage de liaison remettant alors à la pression atmosphérique le volume de la zone d'accouplement 6 pour autoriser le désaccouplement de la boîte de transport 1 à l'écart de l'interface 2,

Entre les périodes d'utilisation, une fois la boite de transport 1 adaptée à l'interface 2 et la porte de boite 1c ouverte, l'interface 2 peut être mis sous vide ce qui permet de faire également le vide dans la boite, et de procéder ainsi à la décontamination de la boite de transport 1 par dégazage.

La présente invention n'est pas limitée aux modes de réalisation qui ont été explicitement décrits, mais elle en inclut les diverses variantes et généralisations qui sont à la portée de l'homme du métier. La présente invention est défini par les revendications.

## Revendications

1. Ensemble comportant :
- une boîte de transport (1) pour substrats (4) tels que des substrats semi-conducteurs, ayant un corps de boîte (1a) muni de parois et comportant une ouverture (1b), une porte (1c) obturant l'ouverture (1b) de manière étanche, et un panier (3) logé dans le corps de boîte (1a) dans lequel peuvent être rangés des substrats (4),
∘ le panier (3) étant déplaçable à travers l'ouverture (1 b) pour son logement dans le corps de boite (1a) et pour sa sortie à l'extérieur du corps de boîte (1 a), et
∘ le panier (3) étant formé de l'empilement d'une série de plateaux (3a-3f) parallèles, supportant chacun un substrat (4), les plateaux (3a-3f) étant emboîtés les uns sur les autres lorsque la porte (1c) est fermée, et les plateaux étant déplaçables à l'écart les uns des autres, selon une direction de déplacement perpendiculaire au plan des substrats (4), lorsque la porte (1c) est ouverte,
∘ la boîte de transport (1) comprenant en outre des moyens (1c, 1 h, 1i) pour comprimer les plateaux (3a-3f) les uns contre les autres dans le corps de boîte (1 a) lorsque celui-ci est fermé par la porte (1 c), ces moyens comprenant des butées élastiques (1i, 1h) autorisant en outre un déplacement avec exces de la porte de boite (1c) vers l'intérieur de la boite de transport (1) sans être bloqué par la pile des plateaux (3a-3f),
- une interface entre ladite boîte de transport (1) et un équipement de traitement (200) des substrats, ladite interface comprenant :
∘ une enceinte d'interface (2a) comprenant un orifice d'accès (2b) pour s'accoupler de manière étanche à la boîte de transport (1) au moyen d'un joint d'étanchéité frontal d'interface (2m), et un orifice de passage (2c) coopérant avec l'équipement (200),
∘ des moyens de réception (2k) pour recevoir et tenir la boite de transport (1) avec sa porte (1c) face à l'ouverture d'accès (2b),
∘ des moyens d'actionnement de panier pour déplacer le panier (3) contenant les substrats (4) entre la boîte de transport (1) et l'enceinte d'interface (2a),
∘ un robot (5) pour la préhension et te transfert des substrats (4) entre le panier (3) dans l'enceinte (2a) de l'interface (2) et l'équipement (200),
∘ des moyens d'actionnement de plateaux (2e, 2f-2i) adaptés pour écarter sélectivement un plateau (3c) choisi vis-à-vis d'un ou des plateaux adjacents (3b, 3d) selon leur direction de déplacement, de façon à permettre au robot (5) de prendre et déplacer sélectivement un substrat (4a) vers ou à l'écart du plateau choisi (3c),
- un joint d'étanchéité frontal d'interface (2m) interposé entre la boîte de transport (1) et l'interface (2), ledit joint d'étanchéité frontal d'interface (2m) constituant un moyen d'étanchéité périphérique isolant de l'atmosphère extérieure une zone d'accouplement (6) entre les faces frontales respectives de la boîte de transport (1) et de l'interface (2) autour de l'ouverture (1b) de boîte de transport (1) et de l'orifice d'accès (2b) de l'interface (2), et
- des moyens de pompage de liaison pour faire le vide dans ladite zone d'accouplement (6).

2. Ensemble selon la revendication 1, dans laquelle, en position empilée des plateaux (3a-3f), la distance (E) entre les substrats (4) adjacents est inférieure à 5 mm environ.

3. Ensemble selon l'une des revendications 1 et 2, dans laquelle le panier (3) est solidaire de la porte (1c).

4. Ensemble selon l'une des revendications précédentes, dans laquelle, en position empilée des plateaux (3a-3f), les zones périphériques des plateaux adjacents sont jointives sur une portion au moins du pourtour des substrats (4).

5. Ensemble selon l'une des revendications précédentes, dans laquelle chaque plateau (3a-3f) comprend :
- un logement périphérique (34a) ouvert vers l'extérieur et apte à recevoir un verrou de blocage (2f-2i) de plateaux,
- des faces principales opposées (35a, 36a) à formes emboîtantes pour coopérer avec les plateaux adjacents et pour assurer un blocage relatif des plateaux en déplacement transversal parallèlement aux plans des substrats (4),
- une face d'appui (236a) pour recevoir la première face d'une portion périphérique d'un substrat (4),
- une face de maintien (235a) pour venir en appui contre la seconde face de la portion périphérique d'un autre substrat,
- les faces d'appui (236a) et de maintien (235a) étant adaptées pour serrer ia portion périphérique d'un substrat (4) entre deux plateaux adjacents.

6. Ensemble selon la revendication 5, dans laquelle la face de maintien (235a) comporte un arrondi (335a).

7. Ensemble selon l'une des revendications 5 et 6, dans laquelle la face de maintien (235a) comporte un relief élastique.

8. Ensemble selon l'une des revendications précédentes, dans laquelle les plateaux (3a-3f) sont conformés pour autoriser leur rotation relative les uns par rapport aux autres, dans leur plan, selon une plage angulaire permettant la correction de l'alignement des substrats (4) qu'ils portent.

9. Ensemble selon l'une des revendications précédentes, comprenant en outre des moyens d'actionnement de porte (2e) pour ouvrir et fermer la porte (1c) de la boîte de transport (1).

10. Ensemble selon l'une des revendications précédentes, destiné à coopérer avec au moins une boîte de transport à plateaux horizontaux, dans laquelle les moyens d'actionnement de plateaux comprennent des moyens de verrouillage de plateau (2f-2i) adaptés pour bloquer sélectivement le mouvement vers le bas d'un plateau choisi (3c), afin d'écarter le plateau choisi (3c) vis-à-vis du plateau adjacent inférieur (3b) et/ou des moyens de verrouillage de plateau (2f∼2i) adaptés pour bloquer sélectivement le mouvement vers le bas du plateau adjacent supérieur (3d) au plateau choisi (3c), afin d'écarter le plateau choisi (3c) du plateau adjacent supérieur (3d).

11. Ensemble selon la revendication 10, dans laquelle les moyens de verrouillage de plateau (2f-2i) comportent des doigts de verrouillage dont l'extrémité s'engage dans un logement (34a) du plateau correspondant (3a) par l'action d'un vérin (2j).

12. Ensemble selon la revendication 10, dans laquelle les moyens de verrouillage de plateau comportent des doigts motorisés (2f-2i).

13. Ensemble selon la revendication 10, dans laquelle les moyens de verrouillage de plateau (2f-2i) comportent un ou plusieurs électroaimants agissant sur une portion ferromagnétique du plateau (33-30) pour assurer le verrouillage.

## Patentansprüche

1. Anordnung, umfassend:
- eine Transportbox (1) für Substrate (4) wie zum Beispiel Halbleitersubstrate mit einem Boxgehäuse (la), das mit Wänden versehen ist und eine Öffnung (1b) umfasst, einer die Öffnung (1b) dicht verschließenden Tür (1c) und einem Magazin (3), das in dem Boxgehäuse (1a) aufgenommen ist und in dem Substrate (4) verstaut werden können,
∘ wobei das Magazin (3) durch die Öffnung (1b) hindurch zwecks seiner Aufnahme im Boxgehäuse (1a) und zwecks seiner Entnahme aus dem Boxgehäuse (1a) heraus verlagerbar ist und
∘ wobei das Magazin (3) aus dem Stapel aus einer Reihe von parallelen Lagerungselementen (3a-3f) gebildet ist, die jeweils ein Substrat (4) tragen, wobei die Lagerungselemente (3a-3f) übereinandergesetzt sind, wenn die Tür (1c) geschlossen ist, und wobei die Lagerungselemente voneinander entlang einer Richtung senkrecht zur Ebene der Substrate (4) beabstandbar sind, wenn die Tür (1c) geöffnet ist,
∘ wobei die Transportbox (1) ferner Mittel (1c, 1h, 1i) umfasst, um die Lagerungselemente (3a-3f) im Boxgehäuse (1a) gegeneinander zusammenzudrücken, wenn dieses durch die Tür (1c) verschlossen wird, wobei diese Mittel elastische Anschläge (1i, 1h) umfassen, die ferner ein Verlagern der Boxtür (1c) mit Überschreitung zum Innenraum der Transportbox (1) hin zulassen, ohne durch den Lagerungselementstapel (3a-3f) blockiert zu werden,
- eine Schnittstelle zwischen der Transportbox (1) und einer Einrichtung zum Bearbeiten (200) der Substrate, wobei die Schnittstelle umfasst:
∘ eine Schnittstellenkammer (2a), umfassend eine Zugangsöffnung (2b), um mittels einer stirnseitigen Schnittstellendichtung (2m) dicht an die Transportbox (1) anzudocken, und eine Durchgangsöffnung (2c), die mit der Einrichtung (200) zusammenwirkt,
∘ Aufnahmemittel (2k), um die Transportbox (1) mit ihrer der Zugangsöffnung (2b) zugewandten Tür (1c) aufzunehmen und zu halten,
∘ Magazinbetätigungsmittel, um das die Substrate (4) enthaltende Magazin (3) zwischen der Transportbox (1) und der Schnittstellenkammer (2a) zu verlagern,
∘ einen Roboter (5) zum Greifen und Transferieren der Substrate (4) zwischen dem Magazin (3) in der Kammer (2a) der Schnittstelle (2) und der Einrichtung (200),
∘ Lagerungselement-Betätigungsmittel (2e, 2f-2i), die geeignet sind, ein gewähltes Lagerungselement (3c) gegenüber einem oder mehreren benachbarten Lagerungselementen (3b, 3d) entlang ihrer Verlagerungsrichtung selektiv zu beabstanden, so dass dem Roboter (5) ermöglicht wird, ein Substrat (4a) zu greifen und selektiv zum gewählten Lagerungselement (3c) hin oder vom gewählten Lagerungselement weg zu verlagern,
- eine stirnseitige Schnittstellendichtung (2m), die zwischen der Transportbox (1) und der Schnittstelle (2) angeordnet ist, wobei die stirnseitige Schnittstellendichtung (2m) ein Umfangsdichtmittel darstellt, das einen Andockbereich (6) zwischen den jeweiligen Stirnseiten der Transportbox (1) und der Schnittstelle (2) um die Öffnung (1b) der Transportbox (1) und die Zugangsöffnung (2b) der Schnittstelle (2) herum von der Außenatmosphäre zu isolieren, und
- Verbindungspumpmittel, um das Vakuum in dem Andockbereich (6) herzustellen.

2. Anordnung nach Anspruch 1, bei der in der gestapelten Stellung der Lagerungselemente (3a-3f) der Abstand (E) zwischen den benachbarten Substraten (4) weniger als etwa 5 mm beträgt.

3. Anordnung nach einem der Ansprüche 1 und 2, bei der das Magazin (3) mit der Tür (1c) fest verbunden ist.

4. Anordnung nach einem der vorhergehenden Ansprüche, bei der in der gestapelten Stellung der Lagerungselemente (3a-3f) die Umfangsbereiche der benachbarten Platten über mindestens einen Abschnitt des Umfangs der Substrate (4) verbunden sind.

5. Anordnung nach einem der vorhergehenden Ansprüche, bei der jedes Lagerungselement (3a-3f) umfasst:
- eine umfängliche Aufnahme (34a), die nach außen offen ist und geeignet ist, einen Lagerungselement-Sperrriegel (2f-2i) aufzunehmen,
- entgegengesetzte Hauptseiten (35a, 36a) mit ineinander passenden Formen, um mit den benachbarten Lagerungselementen zusammenzuwirken und um eine relative Blockierung der Lagerungselemente bei der Querverlagerung parallel zu den Ebenen der Substrate (4) zu gewährleisten,
- eine Auflagefläche (236a), um die erste Seite eines Umfangsabschnitts eines Substrats (4) aufzunehmen,
- eine Haltefläche (235a), um gegen die zweite Seite des Umfangsabschnitts eines anderen Substrats in Anlage zu kommen,
- wobei die Auflageflächen (236a) und Halteflächen (235a) geeignet sind, den Umfangsabschnitt eines Substrats (4) zwischen zwei benachbarten Lagerungselementen einzuspannen.

6. Anordnung nach Anspruch 5, bei der die Haltefläche (235a) eine Rundung (335a) umfasst.

7. Anordnung nach einem der Ansprüche 5 und 6, bei der die Haltefläche (235a) ein elastisches Relief umfasst.

8. Anordnung nach einem der vorhergehenden Ansprüche, bei der die Lagerungselemente (3a-3f) so ausgebildet sind, dass ihre Drehung relativ zueinander in ihrer Ebene gemäß einem Winkelbereich zugelassen wird, was das Korrigieren der Ausrichtung der Substrate (4), die sie tragen, ermöglicht.

9. Anordnung nach einem der vorhergehenden Ansprüche, umfassend ferner Türbetätigungsmittel (2e), um die Tür (1c) der Transportbox (1) zu öffnen und zu schließen.

10. Anordnung nach einem der vorhergehenden Ansprüche, die dazu bestimmt ist, mit mindestens einer Transportbox mit horizontalen Lagerungselementen zusammenzuwirken, wobei die Lagerungselement-Betätigungsmittel Lagerungselement-Verriegelungsmittel (2f∼2i) umfassen, die geeignet sind, die Abwärtsbewegung eines gewählten Lagerungselements (3c) selektiv zu blockieren, um das gewählte Lagerungselement (3c) gegenüber dem unmittelbar darunter liegenden Lagerungselement (3b) zu beabstanden, und/oder Lagerungselement-Verriegelungsmittel (2f-2i), die geeignet sind, die Abwärtsbewegung des Lagerungselements (3d), das unmittelbar über dem gewählten Lagerungselement (3c) liegt, selektiv zu blockieren, um das gewählte Lagerungselement (3c) von dem unmittelbar darüber liegenden Lagerungselement (3d) zu beabstanden.

11. Anordnung nach Anspruch 10, bei der die Lagerungselement-Verriegelungsmittel (2f-2i) Verriegelungsfinger umfassen, deren Ende durch die Wirkung eines Zylinders (2j) in eine Aufnahme (34a) des entsprechenden Lagerungselements (3a) greift.

12. Anordnung nach Anspruch 10, bei der die Lagerungselement-Verriegelungsmittel motorisch angetriebene Finger (2f-2i) umfassen.

13. Anordnung nach Anspruch 10, bei der die Lagerungselement-Verriegelungsmittel (2f-2i) einen oder mehrere Elektromagnete umfassen, die auf einen ferromagnetischen Abschnitt des Lagerungselements (33-30) wirken, um die Verriegelung zu gewährleisten.

## Claims

1. Assembly comprising:
- a transportation box (1) for substrates (4) such as semiconductor substrates, having a box body (1a) provided with walls and comprising an opening (1b), a door (1c) closing the opening (1b) in a sealing manner, and a basket (3) which is housed in the box body (1a) and in which it is possible to store substrates (4),
∘ the basket (3) being movable through the opening (1b) to be housed in the box body (1a) and to be removed from the box body (1a), and
∘ the basket (3) being made up of a stacked set of parallel trays (3a-3f), each supporting a substrate (4), the trays (3a-3f) being nested one on top of another when the door (1c) is closed, and the trays being movable away from one another, in a direction of movement perpendicular to the plane of the substrates (4), when the door (1c) is open,
o the transportation box (1) further comprising means (1c, 1h, 1i) for compressing the trays (3a-3f) against one another in the box body (1a) when the latter is closed by the door (1c), these means comprising elastic stops (1i, 1h) that further permit excess movement of the box door (1c) towards the interior of the transportation box (1) without being blocked by the stack of trays (3a-3f),
- an interface between said transportation box (1) and a piece of equipment (200) for processing the substrates, said interface comprising:
o an interface enclosure (2a) comprising an access orifice (2b) for coupling, in a sealing manner, to the transportation box (1) by means of a frontal interface seal (2m), and a passage orifice (2c) that cooperates with the equipment (200),
o receiving means (2k) for receiving and holding the transportation box (1) with its door (1c) facing the access opening (2b),
o basket actuation means for moving the basket (3) containing the substrates (4) between the transportation box (1) and the interface enclosure (2a),
o a robot (5) for gripping and transferring the substrates (4) between the basket (3) in the enclosure (2a) of the interface (2) and the equipment (200),
o tray actuation means (2e, 2f-2i) that are designed to selectively move a chosen tray (3c) away from a or the adjacent trays (3b, 3d) in their direction of movement, so as to allow the robot (5) to selectively take and move a substrate (4a) towards or away from the chosen tray (3c),
- a frontal interface seal (2m) interposed between the transportation box (1) and the interface (2), said frontal interface seal (2m) constituting a peripheral sealing means that isolates, from the outside atmosphere, a coupling zone (6) between the respective frontal faces of the transportation box (1) and of the interface (2), around the opening (1b) of the transportation box (1) and the access orifice (2b) of the interface (2), and
- connection pumping means for creating a vacuum in said coupling zone (6).

2. Assembly according to Claim 1, in which, in the stacked position of the trays (3a-3f), the distance (E) between the adjacent substrates (4) is less than approximately 5 mm.

3. Assembly according to either of Claims 1 and 2, in which the basket (3) is secured to the door (1c).

4. Assembly according to one of the preceding claims, in which, in the stacked position of the trays (3a-3f), the peripheral zones of the adjacent trays meet over a portion at least of the perimeter of the substrates (4).

5. Assembly according to one of the preceding claims, in which each tray (3a-3f) comprises:
- a peripheral recess (34a) that is open to the outside and is able to receive a tray immobilizing lock (2f-2i),
- opposing principal faces (35a, 36a) having nesting shapes in order to cooperate with the adjacent trays and to prevent transverse relative movement of the trays parallel to the planes of the substrates (4),
- a bearing face (236a) for receiving the first face of a peripheral portion of a substrate (4),
- a holding face (235a) for coming to bear against the second face of the peripheral portion of another substrate,
- the bearing face (236a) and holding face (235a) being designed to clamp the peripheral portion of a substrate (4) between two adjacent trays.

6. Assembly according to Claim 5, in which the holding face (235a) comprises a rounded part (335a).

7. Assembly according to either of Claims 5 and 6, in which the holding face (235a) comprises an elastic relief.

8. Assembly according to one of the preceding claims, in which the trays (3a-3f) are shaped to allow them to rotate relative to one another, in their plane, through an angular range which allows for the correction of the alignment of the substrates (4) which they carry.

9. Assembly according to one of the preceding claims, further comprising door actuation means (2e) for opening and closing the door (1c) of the transportation box (1).

10. Assembly according to one of the preceding claims, intended to cooperate with at least one transportation box having horizontal trays, in which the tray actuation means comprise tray locking means (2f-2i) that are designed to selectively prevent the downward movement of a chosen tray (3c) so as to move the chosen tray (3c) away from the adjacent tray (3b) below and/or tray locking means (2f∼2i) that are designed to selectively prevent the downward movement of the adjacent tray (3d) above the chosen tray (3c) so as to move the chosen tray (3c) away from the adjacent tray (3d) above.

11. Assembly according to Claim 10, in which the tray locking means (2f-2i) comprise locking fingers the end of which engages in a recess (34a) of the corresponding tray (3a) by the action of an actuator (2j).

12. Assembly according to Claim 10, in which the tray locking means comprise motorized fingers (2f-2i).

13. Assembly according to Claim 10, in which the tray locking means (2f-2i) comprise one or more electromagnets acting on a ferromagnetic portion of the tray (33-30) to provide locking.
